# EUROPEAN PATENT APPLICATION

(11) **EP 4 615 170 A1**
(43) Date of publication of application: **10.09.2025**
(21) Application number: 23890215.9
(22) Date of filing: 30.06.2023
(51) Int. Cl.: H05K 1/02

(54) **WIRING CARRIER BOARD AND MANUFACTURING METHOD THEREFOR**

(30) Priority: 15.11.2022 CN 202211429146
(71) Applicant: Huawei Technologies Co., Ltd., Shenzhen, Guangdong 518129 (CN)
(72) Inventor: LI, Juan, Shenzhen, Guangdong 518129 (CN); LI, Zhihang, Shenzhen, Guangdong 518129 (CN); YANG, Yulong, Shenzhen, Guangdong 518129 (CN)
(74) Representative: Pfenning, Meinig & Partner mbB
(86) International application number: PCT/CN2023/104431
(87) International publication number: WO 2024/103773

(57) **Abstract**

This application relates to a routing board and a manufacturing method thereof. The routing board includes: a first build-up layer, an intermediate layer, and a printed circuit board that are stacked in sequence, where the printed circuit board includes a first surface and a second surface that are provided opposite to each other, and the intermediate layer covers the first surface of the printed circuit board; and the first build-up layer is located on the intermediate layer, and traces in the first build-up layer are electrically connected to traces in the printed circuit board through a plurality of conductive vias in the intermediate layer. The provided routing board has a simple structure, has characteristics of super flatness, high density, high speed, high bandwidth, and the like, and has low costs. The routing board can replace an FCBGA board for various packaging scenarios, and has clear advantages in large-size structures.

## Description

This application claims priority to Chinese Patent Application No. 202211429146.9, filed with the China National Intellectual Property Administration on November 15, 2022 and entitled "ROUTING BOARD AND MANUFACTURING METHOD THEREOF", which is incorporated herein by reference in its entirety.

### TECHNICAL FIELD

This application relates to the field of electronic packaging technologies, and in particular, to a routing board and a manufacturing method thereof.

### BACKGROUND

An FCBGA (Flip Chip Ball Grid Array) board (also referred to as an FCBGA organic substrate, which is a high-density IC package substrate used in flip chip ball grid array packaging) is widely used in package architectures in the field of information and communications technology (ICT, information and communications technology), for example, computing. However, due to a high manufacturing threshold and a high price, the FCBGA board accounts for nearly 60% to 70% of costs of an entire package module.

Because the FCBGA board is prepared through build-up (build up) by using a vacuum laminator with a build-up dielectric film (Ajinomoto build-up film, ABF) material, surface flatness less than or equal to 15 µm can be obtained, which can match fine line fabrication of 5/5 µm to 15/15 µm. The FCBGA board usually includes symmetric build-up layers. In addition, as a quantity of chip pins increases, a quantity of layers increases, and an area of each individual unit (Unit) becomes larger, resulting in greater difficulty in manufacturing. For example, in the related technology, a quantity of times of FCBGA build-up applied to mass production has reached nine, a unit size is 60 mm to 100 mm, a yield loss is high, a manufacturing threshold is high, and costs are high, which has restricted wide application of the FCBGA board. In addition, nine times of build-up have also been close to a manufacturing capacity limit of the FCBGA board. However, there are a plurality of concurrent paths in the industry for further development toward high density and a plurality of layers, but have not reached an application stage for mass production.

### SUMMARY

In view of this, a routing board and a manufacturing method thereof are provided. The prepared routing board can replace an FCBGA board, has a simple structure, low costs, and high flatness, and is suitable for various packaging scenarios.

According to a first aspect, an embodiment of this application provides a routing board, including: a first build-up layer, an intermediate layer, and a printed circuit board that are stacked in sequence, where
the printed circuit board includes a first surface and a second surface that are provided opposite to each other, and the intermediate layer covers the first surface of the printed circuit board; and
the first build-up layer is located on the intermediate layer, and traces in the first build-up layer are electrically connected to traces in the printed circuit board through a plurality of conductive vias in the intermediate layer.

The routing board provided according to the first aspect has a simple structure, has characteristics of super flatness, high density, high speed, high bandwidth, and the like, and has low costs. The routing board can replace an FCBGA board for various independent package or MCM (MultiChip Module, multichip module) module structures, and has clear advantages in large-size structures. In addition, the routing board provided in embodiments of this application is suitable for various scenarios, such as a large-bandwidth/large-capacity memory of an XPU, an interconnection between a plurality of XPU chips, a large quantity of serial interfaces of a switch chip, and replacement of a conventional XPU module scheme.

In a possible implementation, the routing board further includes: a second build-up layer, located on the second surface of the printed circuit board. In this way, a quantity of routing layers of the entire routing board can be increased.

In a possible implementation, both a material of an insulating medium in the intermediate layer and a material of an inter-layer insulating medium in the second build-up layer include a preset material, and the preset material includes a build-up dielectric film ABF; and/or
the material of the inter-layer insulating medium in the second build-up layer further includes a prepreg.

In a possible implementation, a material of an insulating medium in the intermediate layer includes an epoxy molding compound EMC, and a material of an inter-layer insulating medium in the first build-up layer includes a build-up dielectric film ABF.

In a possible implementation, the routing board further includes: at least one pair of symmetric build-up layers, where each pair of symmetric build-up layers includes a third build-up layer and a fourth build-up layer;
third build-up layers are provided in sequence on the first build-up layer; and
fourth build-up layers are provided in sequence on the second build-up layer.

In this way, a quantity of routing layers of the routing board can be increased based on the symmetric build-up layers.

In a possible implementation, a material of the intermediate layer includes a build-up dielectric film ABF, a material of an inter-layer insulating medium in the second build-up layer and a material of an inter-layer insulating medium in the printed circuit board are the same, and a material of an inter-layer insulating medium in the third build-up layer and a material of an inter-layer insulating medium in the fourth build-up layer are the same in each pair of symmetric build-up layers.

In a possible implementation, a thickness of the third build-up layer and a thickness of the fourth build-up layer are the same in each pair of symmetric build-up layers. In this way, consistency between stress on the first surface and stress on the second surface of the printed circuit board can be increased, and warpage of the entire routing board and other problems can be resolved.

In a possible implementation, at least one of the first build-up layer, the second build-up layer, the third build-up layer, and the fourth build-up layer is a redistribution layer.

According to a second aspect, an embodiment of this application provides a method for manufacturing a routing board, including:
preparing an auxiliary layer and a to-be-ground layer in sequence on a second surface of a pre-prepared printed circuit board;
grinding the to-be-ground layer, and press-grinding an intermediate layer film covering a first surface of the printed circuit board to form an intermediate layer; and
preparing a first build-up layer on the intermediate layer, and removing the auxiliary layer and a ground layer, to obtain the routing board.

In the second aspect, based on the auxiliary layer and the to-be-ground layer that are prepared in sequence on the second surface of the printed circuit board, and then "grinding the to-be-ground layer, and press-grinding an intermediate layer film covering a first surface of the printed circuit board to form an intermediate layer", it can be ensured that a surface that is of the formed intermediate layer and that is in contact with the first surface of the printed circuit board matches the first surface of the printed circuit board in shape, and a surface that is of the intermediate layer and that is away from the printed circuit board has super flatness, which meets a requirement for the flatness of the exposed surface of the intermediate layer for subsequent preparation of the first build-up layer.

In a possible implementation, the grinding the to-be-ground layer, and press-grinding an intermediate layer film covering a first surface of the printed circuit board to form an intermediate layer includes:
press-grinding the intermediate layer film covering the first surface of the printed circuit board to form the intermediate layer after grinding the to-be-ground layer; or
grinding the to-be-ground layer after press-grinding the intermediate layer film covering the first surface of the printed circuit board to form the intermediate layer; or
grinding the to-be-ground layer while press-grinding the intermediate layer film covering the first surface of the printed circuit board to form the intermediate layer.

In a possible implementation, the method further includes:
preparing a second build-up layer on the second surface of the printed circuit board after removing the auxiliary layer and the ground layer.

In a possible implementation, both a material of an insulating medium in the intermediate layer and a material of an inter-layer insulating medium in the second build-up layer include a preset material, and the preset material includes a build-up dielectric film ABF; and/or
the material of the inter-layer insulating medium in the second build-up layer further includes a prepreg.

In a possible implementation, a material of an insulating medium in the intermediate layer includes an epoxy molding compound EMC, and a material of an inter-layer insulating medium in the first build-up layer includes a build-up dielectric film ABF.

In a possible implementation, the method further includes:
in a case that the routing board further includes one symmetric build-up layer, forming a third build-up layer on the first build-up layer, and forming a fourth build-up layer on the second build-up layer; or
in a case that the routing board further includes at least two symmetric build-up layers, forming a third build-up layer on the first build-up layer and forming a fourth build-up layer on the second build-up layer; and forming a third build-up layer in a next pair of symmetric build-up layers on the currently exposed third build-up layer and forming a fourth build-up layer in the next pair of symmetric build-up layers on the currently exposed fourth build-up layer, until all the symmetric build-up layers are prepared.

In a possible implementation, a material of an insulating medium in the intermediate layer includes a build-up dielectric film ABF, a material of an inter-layer insulating medium in the second build-up layer and a material of an inter-layer insulating medium in the printed circuit board are the same, and a material of an inter-layer insulating medium in the third build-up layer and a material of an inter-layer insulating medium in the fourth build-up layer are the same in each pair of symmetric build-up layers.

In a possible implementation, a thickness of the third build-up layer and a thickness of the fourth build-up layer are the same in each pair of symmetric build-up layers.

In a possible implementation, at least one of the first build-up layer, the second build-up layer, the third build-up layer, and the fourth build-up layer is a redistribution layer.

Beneficial effects of the method for manufacturing the routing board provided in the second aspect and in the possible implementations of the second aspect are correspondingly the same as those of the routing board provided in the first aspect and in the possible implementations of the first aspect. To avoid repetition, details are not described herein again.

These aspects and other aspects of this application are more concise and more comprehensive in descriptions of the following (plurality of) embodiments.

### BRIEF DESCRIPTION OF DRAWINGS

Accompanying drawings included in this specification and constituting a part of this specification and this specification jointly show example embodiments, features, and aspects of this application, and are intended to explain principles of this application.
FIG. 1 is a diagram of a structure of a routing substrate in related technology 1;
FIG. 2A and FIG. 2B are respectively diagrams of structures of a routing substrate in two implementations in related technology 2;
FIG. 3 is a diagram of a structure of a routing board in related technology 3;
FIG. 4 is a diagram of a structure of a routing board in related technology 4;
FIG. 5A and FIG. 5B are respectively a structural diagram and a schematic processing flowchart of a routing board 100 according to an embodiment of this application;
FIG. 6 is a schematic processing flowchart of a printed circuit board according to an embodiment of this application;
FIG. 7A and FIG. 7B are respectively a structural diagram and a schematic processing flowchart of a routing board 200 according to an embodiment of this application;
FIG. 8A and FIG. 8B are respectively a structural diagram and a schematic processing flowchart of a routing board 300 according to an embodiment of this application; and
FIG. 8C is a schematic processing flowchart of a routing board 300 according to an embodiment of this application.

### DESCRIPTION OF EMBODIMENTS

The following describes various example embodiments, features, and aspects of this application in detail with reference to the accompanying drawings. Identical reference numerals in the accompanying drawings indicate elements that have same or similar functions. Although various aspects of embodiments are illustrated in the accompanying drawings, the accompanying drawings are not necessarily drawn in proportion unless otherwise specified.

The specific term "example" herein means "used as an example, embodiment, or illustration". Any embodiment described as "example" is not necessarily explained as being superior or better than other embodiments.

In addition, to better describe this application, numerous specific details are given in the following specific implementations. A person skilled in the art should understand that this application can also be implemented without some specific details. In some instances, methods, means, elements, and circuits that are well-known to a person skilled in the art are not described in detail, so that a subject matter of this application is highlighted.

The following describes implementations of build-up of FCBGA boards in the related technologies and existing problems.

### Related technology 1:

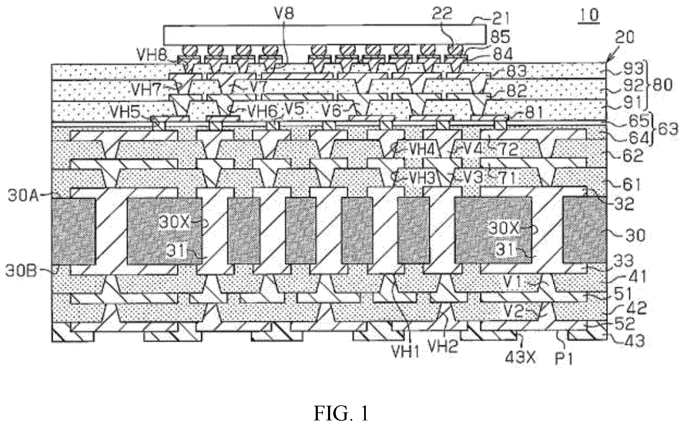

As shown in FIG. 1, in related technology 1 (refer to US20140301058A1), based on a conventional FCBGA board, interface reconstruction is performed by using two dielectric materials: a layer 64 and a layer 65. The layer 64 is a filler-containing material, and the layer 65 is a filler-free material with a surface roughness Ra of 10 nm to 200 nm. Then, a conductor layer 81 and a conductor layer 72 are connected through VH5. As a result, single-surface build-up manufacturing is implemented based on the conventional FCBGA. However, there is a problem of poor mass producibility, which is specifically shown in the following aspects. The layer 64 and the layer 65 are key materials and need to be extremely thin with good uniformity. However, it is difficult to obtain the two ultra-thin materials, so the two ultra-thin materials have not been widely used currently, and costs are high. Via-filling plating for VH5 is difficult, and a size of the via needs to be extremely small. If the via is made by exposure to light, the layer 64 and the layer 65 have to be photosensitive materials. If the via is made by laser drilling, an extremely small laser-drilled via needs to be made, which has high requirements on a laser drilling machine. Currently, the smallest laser-drilled via that can be made has a size of 30 µm. Via-filling plating for the 30 µm laser-drilled via easily causes problems such as an out-of-limit thickness of the conductive layer 81 and filled via collapse, and consequently, it is more difficult for subsequent build-up of media 91 to 93.

### Related technology 2:

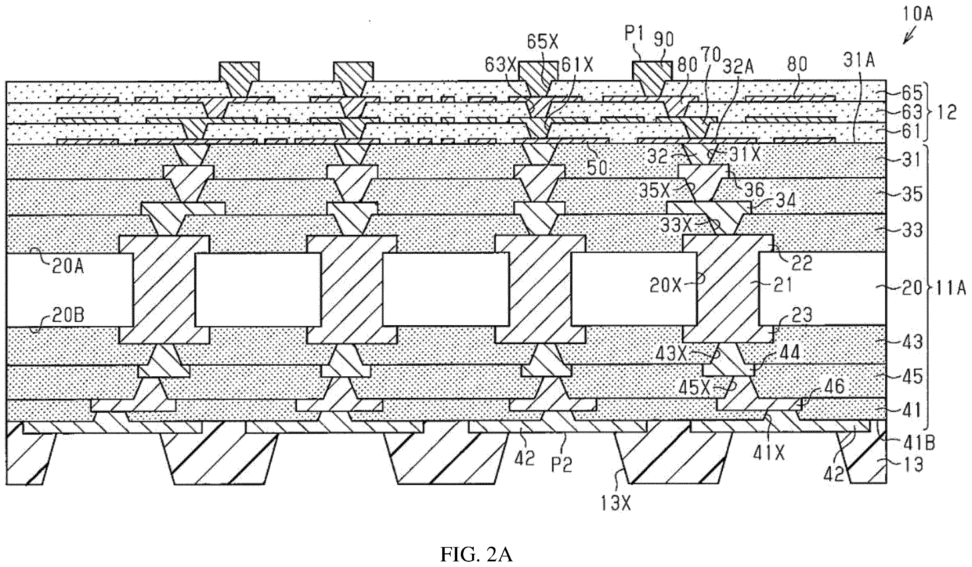

As shown in FIG. 2A, in a first implementation (refer to US20160020163A1) of related technology 2, based on a conventional FCBGA board, a layer 31 is ground to form a uniform flat surface, and then subsequent build-up manufacturing is performed.

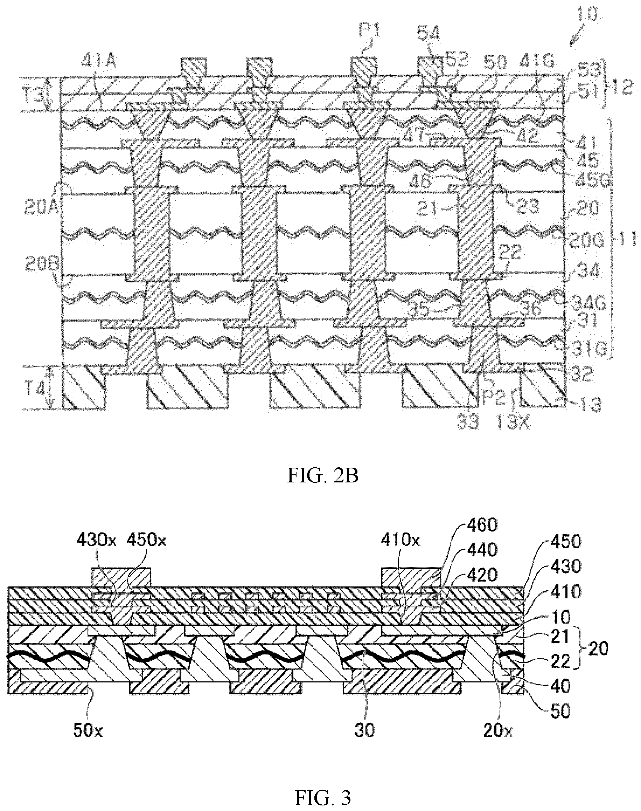

As shown in FIG. 2B, in a second implementation (JP5662551B1) of related technology 2, based on a high-density interconnection HDI (high Density Interconnection) board, a layer 41 is ground to form a uniform flat surface, and then subsequent build-up manufacturing is performed.

However, there is also a problem of poor mass producibility in related technology 2, which is specifically shown in the following aspects. In the foregoing two implementations of related technology 2, bare copper is directly ground, which is very difficult to implement due to ductility of copper, resulting in poor mass producibility. In addition, in the second implementation, a glass fiber cloth is exposed from the layer 41 with the glass fiber cloth after grinding, leading to a high reliability risk and no mass producibility. Moreover, in the foregoing two implementations of related technology 2, a bottom surface of the structure is not treated in any way, and there is a vacuum leak problem during subsequent processing, resulting in poor operability and poor mass producibility.

### Related technology 3:

As shown in FIG. 3, in this solution (US11152293B2), a conductor layer 10 is first prepared with the help of an interposer layer (Carrier), and then a layer 20 is prepared in steps. In particular, there is only one layer 22, and a conductor layer 40 is in a regular trapezoid or a quadrilateral shape. However, there are problems as follows. Costs are high, and two interposer layers are required. It is difficult to build up a plurality of layers 22. All these result in poor mass producibility.

### Related technology 4:

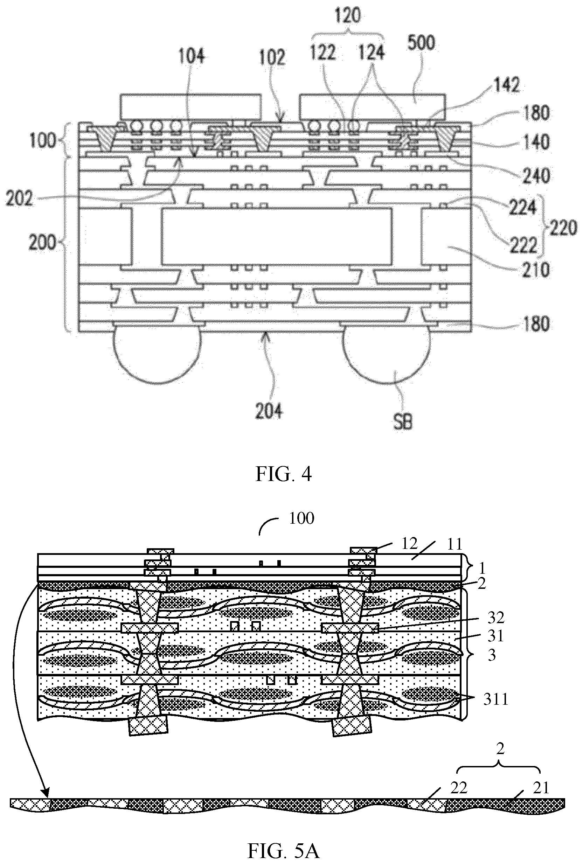

As shown in FIG. 4, in this solution (CN110581075A), a layer 100 is directly built up based on a layer 200, and then the layer 100 and the layer 200 are connected by using a conductor 142. However, there are problems as follows. The layer 100 and the layer 200 can be connected only by using the conductor 142, and a size of the conductor 142 is usually greater than or equal to 70 µm, which affects application of high-density redistribution lines. Direct build-up on HDI leads to poor flatness of the entire board and a low assembly yield.

An FCBGA board is required in a conventional architecture of a computing XPU (such as a TPU, an IPU, or an NPU). A conventional FCBGA board has bottlenecks in high-speed performance and availability. In the related technology, to resolve the foregoing problems, package architecture-level innovation continues to be carried out. A solution is provided mainly from two dimensions: "top-down" structure innovation at a water level and "bottom-up" structure innovation at a board level. To resolve the foregoing technical problems, embodiments of this application provide a routing board, which belongs to a "bottom-up" innovative architecture, and can provide an integrated architecture with super flatness comparable to that of the FCBGA. The routing board has a simple structure, has characteristics of super flatness, high density, high speed, high bandwidth, and the like, and has low costs. The routing board can replace an FCBGA board for various independent package or MCM (MultiChip Module, multichip module) module structures, such as single-chip packaging, multichip and multi-device packaging, and MCM (MultiChip Module, multichip module)-HDFI (High-Fidelity, high-fidelity chip)+MDFO integrated packaging, and has clear advantages in large-size structures. In addition, the routing board provided in embodiments of this application is suitable for various scenarios, such as a large-bandwidth/large-capacity memory of an XPU, an interconnection between a plurality of XPU chips, a large quantity of serial interfaces of a switch chip, and replacement of a conventional XPU module scheme.

As shown in FIG. 5A, a routing board 100 provided in an embodiment of this application includes a first build-up layer 1, an intermediate layer 2, and a printed circuit board 3 that are stacked in sequence. The printed circuit board 3 includes a first surface and a second surface that are provided opposite to each other. The intermediate layer 2 covers the first surface of the printed circuit board 3. The first build-up layer 1 is located on the intermediate layer 2. Traces in the first build-up layer 1 are electrically connected to traces in the printed circuit board 3 through a plurality of conductive vias (via) 22 in the intermediate layer 2. The conductive vias 22 (and other conductive vias in this specification) may be through holes plated with a metal on inner surfaces or through holes filled with a metal.

In this embodiment, the printed circuit board 3 may be a printed circuit board prepared by using a high-density interconnector (High Density Interconnector, HDI) technology, and a quantity of layers of the printed circuit board 3 may be set according to an actual requirement. This is not limited in this application. In some embodiments, a material of an inter-layer insulating medium 31 in the printed circuit board 3 may include polymer resin, a filler (filler) 311, and a glass fiber reinforced material. In a possible implementation, a material of the inter-layer insulating medium 31 in the printed circuit board 3 may be provided as a 112G high-speed material or a high-frequency material, to expand an application scenario and significantly improve high-frequency and high-speed performance of the integrated routing board. A conductive via 32 in the printed circuit board 3 may be made by laser drilling. This is not limited in this application. The conductive via in the printed circuit board 3 may be a metalized hole or a metal-filled hole, and each conductive via 32 may be a hole required for routing of the printed circuit board, such as a through hole or a blind hole. This is not limited in this application.

In this embodiment, the first build-up layer 1 in the routing board 100 may be a redistribution layer (ReDistribution Layer, RDL), and a material of an insulating medium in the redistribution layer and a quantity of redistribution layers may be set based on a material of the insulating medium in the intermediate layer, a routing requirement, and the like. This is not limited in this application. The first build-up layer 1 is provided as a redistribution layer, which can implement routing of a minimum line width/spacing of 2 µm/2 µm, a conductive via (via, also referred to as a via hole) size of 5 µm to 20 µm (for example, 10 µm), and a bump pitch (bump pitch) of 30 µm to 50 µm. Based on the entire routing board, a close-interval design capability can be significantly improved, and even a die (die) can be directly soldered to the first build-up layer to implement chip-on-board.

In some embodiments, a material of the insulating medium in the intermediate layer 2 may be a thermosetting film with a low coefficient of thermal expansion (coefficient of thermal expansion, CTE) and a low dielectric loss (dielectric loss), and has characteristics of good mechanical performance and good durability. In some embodiments, a material of the insulating medium in the intermediate layer 2 may be a build-up dielectric film ABF, an epoxy molding compound EMC (Epoxy Molding Compound, also referred to as an epoxy encapsulant material), or the like. For example, a material of the intermediate layer 2 may include polymer resin and a filler (for example, the filler may be a prepreg (prepreg)), where a maximum diameter D100 of the filler may be less than or equal to 10 µm (for example, 5 µm). A maximum diameter of the filler, a ratio of a coefficient of thermal expansion α1 of the filler to a coefficient of thermal expansion α2 of the polymer resin, a modulus of the intermediate layer, a thickness, a volume ratio of the conductive vias 22 to the intermediate layer 2, a shape and distribution of the conductive vias 22, and the like may be set according to an actual requirement. This is not limited in this application.

In a possible implementation, if a material of the insulating medium in the intermediate layer 2 is an EMC, a material of an inter-layer insulating medium in the first build-up layer may be an ABF.

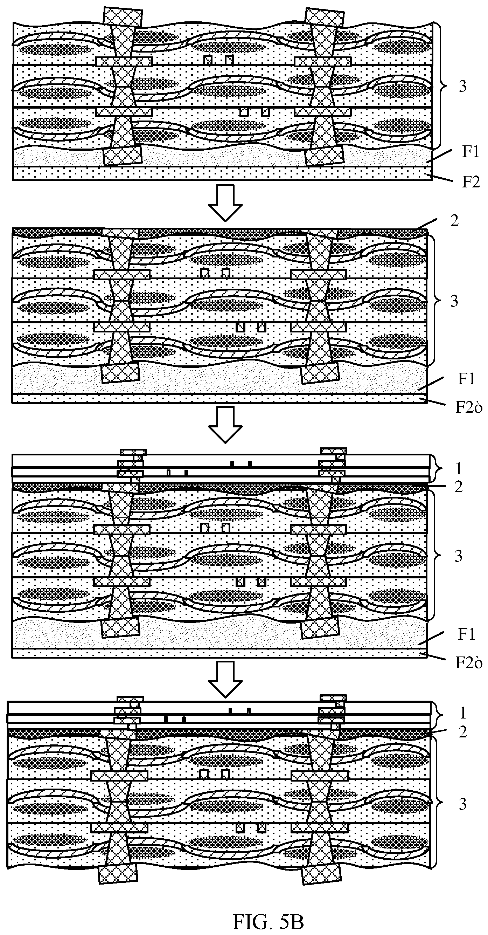

As shown in FIG. 5B, in the schematic processing flowchart of manufacturing the routing board 100 shown in FIG. 5A, a method for manufacturing the routing board 100 shown in FIG. 5A may include the following steps. An auxiliary layer F1 and a to-be-ground layer F2 are formed in sequence on a second surface of a pre-prepared printed circuit board 3. Then, the to-be-ground layer F2 is ground, and an intermediate layer film covering a first surface of the printed circuit board 3 is press-ground to form an intermediate layer 2. The first build-up layer 1 is prepared on the intermediate layer 2, and the auxiliary layer F1 and the ground layer F2' are removed, to obtain the routing board 100 shown in FIG. 5A (or the auxiliary layer F1 and the ground layer F2' may be first removed, and the first build-up layer 1 is prepared on the intermediate layer 2, to obtain the routing board 100 shown in FIG. 5A).

In this embodiment, based on the auxiliary layer F1 and the to-be-ground layer F2 that are prepared in sequence on the second surface of the printed circuit board 3, and then "the to-be-ground layer F2 is ground, and an intermediate layer film covering a first surface of the printed circuit board 3 is press-ground to form an intermediate layer 2", it can be ensured that a surface that is of the formed intermediate layer 2 and that is in contact with the first surface of the printed circuit board 3 matches the first surface of the printed circuit board 3 in shape, and a surface that is of the intermediate layer 2 and that is away from the printed circuit board 3 has super flatness, which meets a requirement for the flatness of the exposed surface of the intermediate layer 2 for subsequent preparation of the first build-up layer 1. In some embodiments, that the to-be-ground layer F2 is ground, and an intermediate layer film covering a first surface of the printed circuit board 3 is press-ground to form an intermediate layer 2 may include any one of the following operations: press-grinding the intermediate layer film covering the first surface of the printed circuit board to form the intermediate layer after grinding the to-be-ground layer; or grinding the to-be-ground layer after press-grinding the intermediate layer film covering the first surface of the printed circuit board to form the intermediate layer; or grinding the to-be-ground layer while press-grinding the intermediate layer film covering the first surface of the printed circuit board to form the intermediate layer.

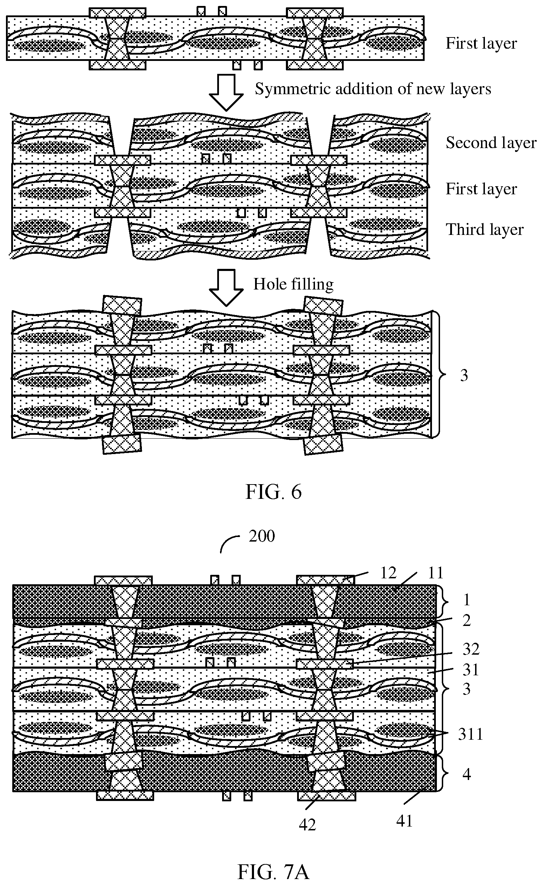

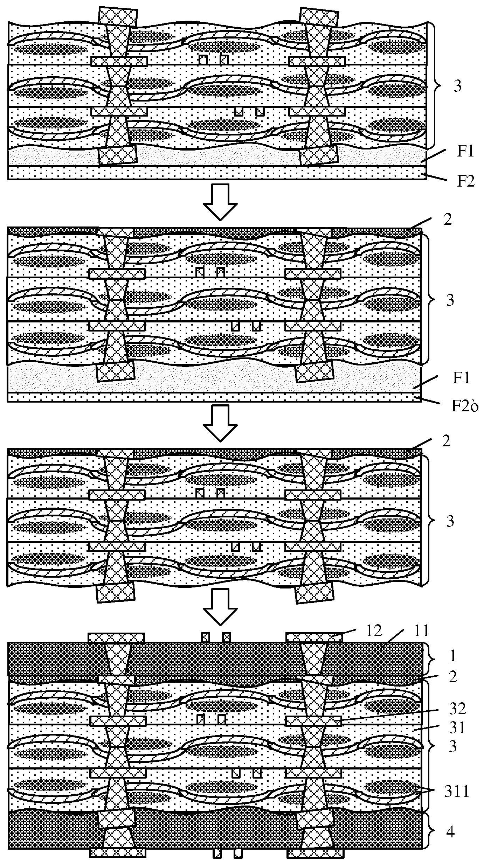

In some embodiments, the method for manufacturing the routing board 100 may further include a step of manufacturing the printed circuit board. As shown in FIG. 6, in the step of manufacturing the printed circuit board, a first-layer structure is prepared first, then a second-layer structure and a third-layer structure are prepared respectively on an upper surface and a lower surface of the first-layer structure, and then holes are made and filled on the second-layer structure and the third-layer structure, to obtain the printed circuit board 3. The printed circuit board 3 includes a five-layer, seven-layer, or nine-layer structure. In this case, after the holes are made and filled on the second-layer structure and the third-layer structure, the current structure may be used as a "first-layer structure", and the steps after the manufacturing of the first-layer structure are repeatedly performed until all layers are prepared. In some embodiments, a thickness of the second-layer structure may be the same as a thickness of the third-layer structure. In this way, new structural layers are added on an upper surface and a lower surface of a "first-layer structure" symmetrically, so that warpage (Warpage) of the routing board 100 and other problems can be resolved, and further warpage (Warpage) of the entire routing board 100 and other problems can be resolved.

In some embodiments, FIG. 5B and FIG. 6 merely show examples of a process of manufacturing a single routing board 100. In a batch production process, actually, a plurality of routing boards 100 are prepared in batches at a time. In this case, a method for manufacturing routing boards 100 in batches has the following two implementations.

Implementation 1: If an entire PCB panel (panel) with a plurality of printed circuit boards connected together is obtained, that is, a plurality of printed circuit boards connected together (where the printed circuit boards have same structures) may be prepared each time through the step of manufacturing the printed circuit board, adjacent printed circuit boards and gaps in between form a panel, and the panel is cut, to obtain a plurality of individual printed circuit boards. In this case, in the method for manufacturing routing boards in batches, an auxiliary layer and a to-be-ground layer may be directly prepared in sequence on a second surface of the panel including the plurality of printed circuit boards (that is, a second surface of each printed circuit board). After the to-be-ground layer is ground, the panel with the auxiliary layer and the ground layer is fastened to a temporary carrier (such as a glass plate or a stainless steel plate), and then press-grinding is performed on and holes are made on an intermediate layer film covering a first surface of the panel to form, on the first surface of the entire panel, an intermediate layer covering a surface of each printed circuit board. A first build-up layer is prepared at a position corresponding to each printed circuit board on the intermediate layer, and the auxiliary layer and the ground layer are removed, to obtain a to-be-cut structure that includes a plurality of routing boards 100. The to-be-cut structure is cut to obtain the plurality of routing boards 100.

Implementation 2: If a plurality of individual printed circuit boards are obtained, in the method for manufacturing routing boards 100 in batches, auxiliary layers and to-be-ground layers may be prepared in sequence first on second surfaces of printed circuit boards that need to be prepared in a batch, and then the to-be-ground layers on the second surfaces of the printed circuit boards are ground. After grinding, the plurality of printed circuit boards with the ground layers and the auxiliary layers are fastened to a temporary carrier, a gap between the printed circuit boards is filled with a sacrificial layer, and an intermediate layer film covering first surfaces of the plurality of printed circuit boards is press-ground to form an intermediate layer covering the first surfaces of the plurality of printed circuit boards. A first build-up layer is prepared at a position corresponding to each printed circuit board on the intermediate layer. The auxiliary layers and the ground layers are removed, and the sacrificial layer is removed, to obtain the plurality of routing boards 100.

It needs to be understood that the foregoing implementation 1 and implementation 2 are merely example implementations of manufacturing the routing boards 100 in batches provided in embodiments of this application. A person skilled in the art may set a method for manufacturing the routing boards 100 in batches according to an actual requirement. This is not limited in this application.

An embodiment of this application further provides another routing board 200. As shown in FIG. 7A, the routing board 200 includes a first build-up layer 1, an intermediate layer 2, a printed circuit board 3, and a second build-up layer 4 that are stacked in sequence. The printed circuit board 3 includes a first surface and a second surface that are provided opposite to each other. The intermediate layer 2 covers the first surface of the printed circuit board 3. The first build-up layer 1 is located on the intermediate layer 2. Traces in the first build-up layer 1 are electrically connected to traces in the printed circuit board 3 through a plurality of conductive vias 22 in the intermediate layer 2. The second build-up layer 4 is located on the second surface of the printed circuit board 3. In this way, the routing board 200 has more routing layers than the routing board 100. The routing board 200 and the routing board 100 are provided similarly. For brevity, the following describes only differences between the routing board 200 and the routing board 100. For other same or similar parts, refer to the related descriptions of the routing board 100. The differences between the routing board 200 and the routing board 100 are as follows.

In the routing board 200, both a material of an insulating medium in the intermediate layer 2 and a material of an inter-layer insulating medium in the second build-up layer 3 may include a preset material. The preset material may include a build-up dielectric film ABF. In some embodiments, the material of the inter-layer insulating medium in the second build-up layer further includes a prepreg.

In the routing board 200, the first build-up layer 1 and the second build-up layer 4 may be each a redistribution layer. In some embodiments, in the routing board 200, a material of an inter-layer insulating medium in the first build-up layer 1 may also be a preset material.

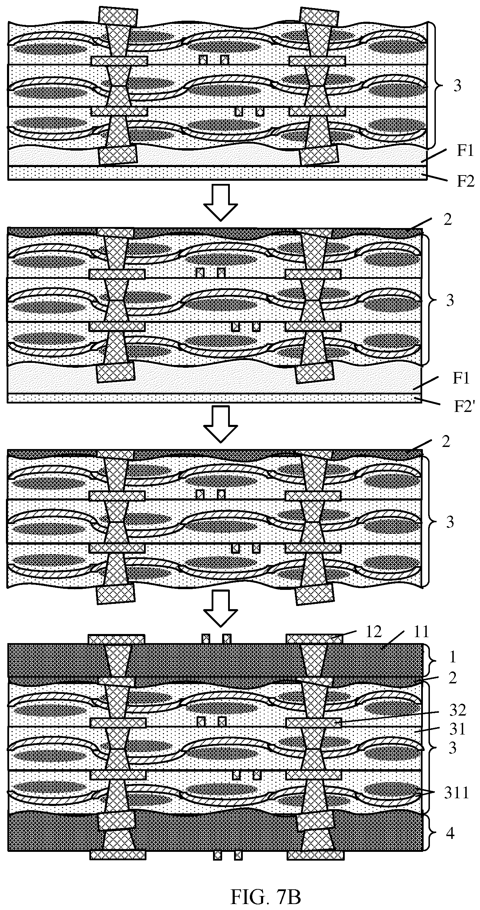

In this embodiment, as shown in FIG. 5B and FIG. 7B, a method for manufacturing the routing board 200 and the method for manufacturing the routing board 100 have similar or same steps. For brevity, the following describes only differences between the method for manufacturing the routing board 200 and the method for manufacturing the routing board 100. For other steps of the method for manufacturing the routing board 200, refer to the corresponding steps in the method for manufacturing the routing board 100. The differences between the routing board 200 and the manufacturing of the routing board 100 are that: after the first build-up layer 1 is prepared and the auxiliary layer F1 and the ground layer F2' are removed, the second build-up layer 4 is prepared on the second surface of the printed circuit board 3, to obtain the routing board 200.

A method for manufacturing routing boards 200 in batches and the method for manufacturing routing boards 100 in batches have the following differences. In implementation 1, after the first build-up layer of each printed circuit board is prepared, the auxiliary layer and the ground layer are removed, the second build-up layer of each printed circuit board is prepared on the second surface of the entire panel, and cutting is performed to obtain the plurality of routing boards 200. In implementation 2, after the first build-up layer of each printed circuit board is prepared, the auxiliary layers and the ground layers are removed, the second build-up layer of each printed circuit board is prepared on the second surfaces of the plurality of printed circuit boards that are connected together with the help of the sacrificial layer, and the sacrificial layer is cut and removed to obtain the plurality of routing boards 200. It needs to be understood that the foregoing implementation 1 and implementation 2 are merely example implementations of manufacturing the routing boards 200 in batches provided in embodiments of this application. A person skilled in the art may set a method for manufacturing the routing boards 200 in batches according to an actual requirement. This is not limited in this application.

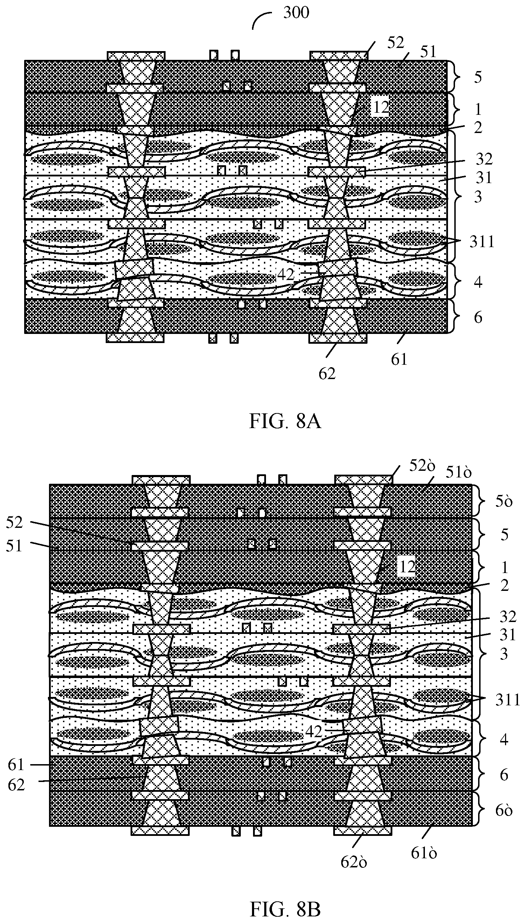

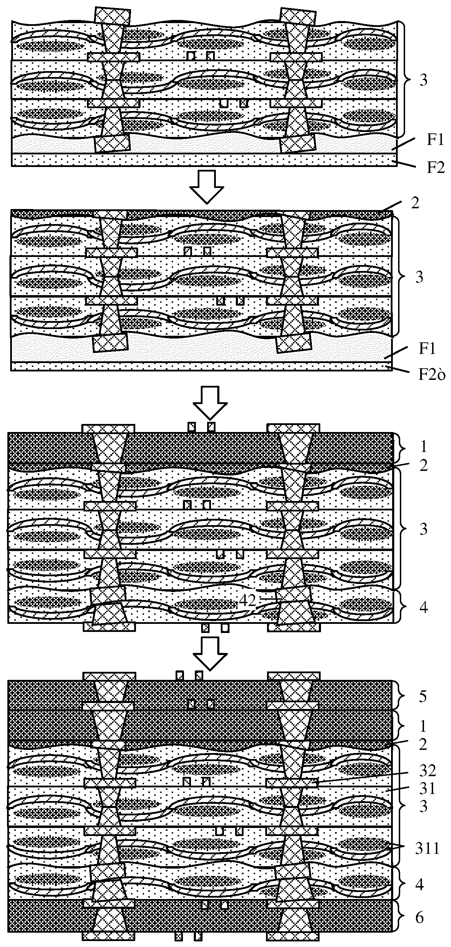

An embodiment of this application further provides still another routing board 300. As shown in FIG. 8A and FIG. 8B, the routing board 300 includes a first build-up layer 1, an intermediate layer 2, a printed circuit board 3, and a second build-up layer 4 that are stacked in sequence, and at least one pair of symmetric build-up layers. Each pair of symmetric build-up layers includes a third build-up layer (5 or 5' shown in FIG. 8A or FIG. 8B) and a fourth build-up layer (6 or 6' shown in FIG. 8A or FIG. 8B). The printed circuit board 3 of the routing board 300 includes a first surface and a second surface that are provided opposite to each other. The intermediate layer 2 covers the first surface of the printed circuit board 3. The first build-up layer 1 is located on the intermediate layer 2. Traces in the first build-up layer 1 are electrically connected to traces in the printed circuit board 3 through a plurality of conductive vias 22 in the intermediate layer 2. The second build-up layer 4 is located on the second surface of the printed circuit board 3. Third build-up layers (5 and 5' shown in FIG. 8A and FIG. 8B) are provided in sequence on the first build-up layer 1. Fourth build-up layers (6 and 6' shown in FIG. 8A and FIG. 8B) are provided in sequence on the second build-up layer 4. For brevity, FIG. 8A provides only an example of a routing board 300 that includes one pair of symmetric build-up layers (5 and 6 shown in FIG. 8A). FIG. 8B provides an example of a routing board 300 that includes two pairs of symmetric build-up layers (as shown in FIG. 8B, a third build-up layer 5 and a fourth build-up layer 6 are a pair of symmetric build-up layers, and a third build-up layer 5' and a fourth build-up layer 6' are a pair of symmetric build-up layers). In this embodiment, a quantity of symmetric build-up layers may be set according to an actual requirement. This is not limited in this application. In this way, the routing board 300 has more routing layers than the routing board 200.

The routing board 300 and the routing board 200 are provided similarly. For brevity, the following describes only differences between the routing board 300 and the routing board 200. For other same or similar parts, refer to the related descriptions of the routing board 200. The differences between the routing board 300 and the routing board 200 are as follows.

In the routing board 300, a material of an insulating medium in the intermediate layer 2 may be a build-up dielectric film ABF, and a material of an inter-layer insulating medium in the second build-up layer 4 and a material of an inter-layer insulating medium in the printed circuit board 3 are the same. A material of an inter-layer insulating medium in the third build-up layer and a material of an inter-layer insulating medium in the fourth build-up layer are the same in each pair of symmetric build-up layers. In this way, consistency between stress on the first surface and stress on the second surface of the printed circuit board 3 can be increased, and warpage of the entire routing board 300 and other problems can be resolved.

In the routing board 300, a thickness of the third build-up layer and a thickness of the fourth build-up layer are the same in each pair of symmetric build-up layers. As shown in FIG. 8A and FIG. 8B, a thickness of the third build-up layer 5 and a thickness of the fourth build-up layer 6 are the same, and a thickness of the third build-up layer 5' and a thickness of the fourth build-up layer 6' are the same. In this way, consistency between stress on the first surface and stress on the second surface of the printed circuit board 3 can also be increased, and warpage of the entire routing board 300 and other problems can be resolved.

In the routing board 300, at least one of the first build-up layer 1, the second build-up layer 4, the third build-up layer, and the fourth build-up layer may be a redistribution layer. In some embodiments, in the routing board 300, a material of an inter-layer insulating medium in the first build-up layer 1 may also be a preset material.

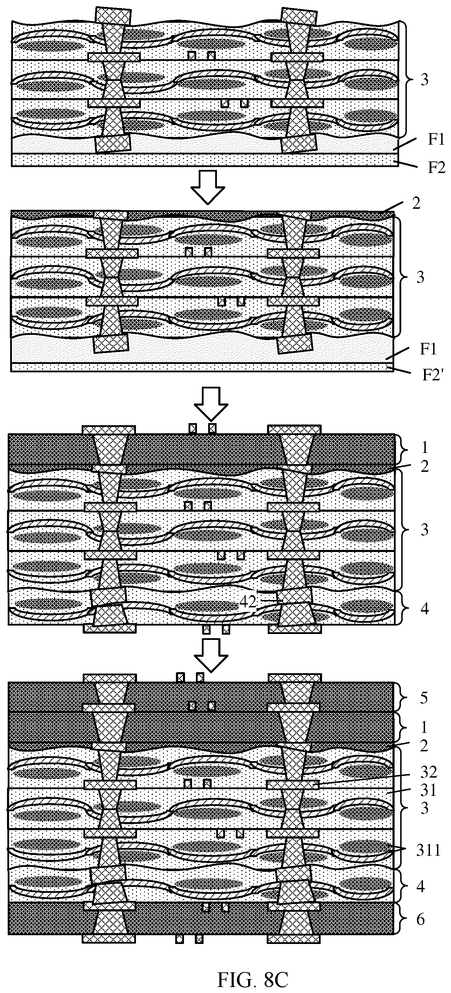

In this embodiment, as shown in FIG. 5B and FIG. 8C, a method for manufacturing the routing board 300 and the method for manufacturing the routing board 100 have similar or same steps. For brevity, the following describes only differences between the method for manufacturing the routing board 300 and the method for manufacturing the routing board 100. For other steps of the method for manufacturing the routing board 300, refer to the corresponding steps in the method for manufacturing the routing board 100. The differences between the routing board 300 and the manufacturing of the routing board 100 are that: after the first build-up layer 1 is prepared and the auxiliary layer F1 and the ground layer F2' are removed, the second build-up layer 4 is prepared on the second surface of the printed circuit board 3. In a case that the routing board 300 includes one symmetric build-up layer as shown in FIG. 8A, the third build-up layer 5 is formed on the first build-up layer 1, and the fourth build-up layer 6 is formed on the second build-up layer 4, to obtain the routing board 300 shown in FIG. 8A. In a case that the routing board 300 includes at least two symmetric build-up layers, the third build-up layer 5 is formed on the first build-up layer 1 and the fourth build-up layer 6 is formed on the second build-up layer 4; and then a third build-up layer in a next pair of symmetric build-up layers is formed on the currently exposed third build-up layer and a fourth build-up layer in the next pair of symmetric build-up layers is formed on the currently exposed fourth build-up layer, until all the symmetric build-up layers are prepared, to obtain the routing board 300.

In some embodiments, in a process of manufacturing each pair of symmetric build-up layers, an inter-layer insulating medium layer of a current layer in the third build-up layer and the fourth build-up layer in the symmetric build-up layers may be first prepared, and then holes are made synchronously on the currently exposed inter-layer insulating medium layer of the third build-up layer and on the currently exposed inter-layer insulating medium layer of the fourth build-up layer, that is, synchronous hole making is implemented on the third build-up layer and the fourth build-up layer in each pair of symmetric build-up layers. In this way, consistency between stress on the first surface and stress on the second surface of the printed circuit board 3 can be increased, and warpage of the entire routing board 300 and other problems can be resolved.

A method for manufacturing routing boards 300 in batches and the method for manufacturing routing boards 100 in batches have the following differences. In implementation 1, after the first build-up layer of each printed circuit board is prepared, the auxiliary layer and the ground layer are removed, and the second build-up layer of each printed circuit board is prepared on the second surface of the entire panel. Then, each pair of symmetric build-up layers of each printed circuit board is prepared on the surface of the entire panel, and then cutting is performed to obtain the plurality of routing boards 300. In implementation 2, after the first build-up layer of each printed circuit board is prepared, the auxiliary layers and the ground layers are removed, the second build-up layer of each printed circuit board is prepared on the second surfaces of the plurality of printed circuit boards that are connected together with the help of the sacrificial layer, then each pair of symmetric build-up layers of each printed circuit board is prepared, and then the sacrificial layer is cut and removed to obtain the plurality of routing boards 300. It needs to be understood that the foregoing implementation 1 and implementation 2 are merely example implementations of manufacturing the routing boards 300 in batches provided in embodiments of this application. A person skilled in the art may set a method for manufacturing the routing boards 300 in batches according to an actual requirement. This is not limited in this application.

The flowcharts and block diagrams in the accompanying drawings show possible implementations of system architectures, functions, and operations of apparatuses, systems, methods, and computer program products according to a plurality of embodiments of this application. In this regard, each block in the flowcharts or block diagrams may represent a module, a program segment, or a part of instructions, and the module, the program segment, or the part of instructions includes one or more executable instructions for implementing a specified logical function. In some alternative implementations, functions marked in the blocks may occur in a sequence different from that marked in the accompanying drawings. For example, two consecutive blocks may actually be executed substantially in parallel, and may sometimes be executed in a reverse sequence, depending on a function involved.

It should also be noted that each block in the block diagrams and/or flowcharts, and a combination of blocks in the block diagrams and/or flowcharts may be implemented by hardware (for example, a circuit or an ASIC (Application-Specific Integrated Circuit, application-specific integrated circuit)) that performs a corresponding function or action, or may be implemented by a combination of hardware and software, for example, firmware.

Although the present invention is described with reference to embodiments, in a process of implementing the present invention that claims protection, a person skilled in the art may understand and implement another variation of the disclosed embodiments by viewing the accompanying drawings, disclosed content, and the appended claims. In the claims, "comprising" (comprising) does not exclude another component or another step, and "a" or "one" does not exclude a case of plurality. A single processor or another unit may implement several functions enumerated in the claims. Some measures are recorded in dependent claims that are different from each other, but this does not mean that these measures cannot be combined to produce great effects.

The foregoing has described embodiments of this application. The foregoing descriptions are examples, not exhaustive, and are not limited to the disclosed embodiments. Many modifications and changes are apparent to a person of ordinary skill in the art without departing from the scope and spirit of the described embodiments. The selection of terms used herein is intended to best explain the principles of the embodiments, practical applications, or improvements to technologies in the market, or to enable another person of ordinary skill in the art to understand the embodiments disclosed herein.

## Claims

1. A routing board, comprising: a first build-up layer, an intermediate layer, and a printed circuit board that are stacked in sequence, wherein
the printed circuit board comprises a first surface and a second surface that are provided opposite to each other, and the intermediate layer covers the first surface of the printed circuit board; and
the first build-up layer is located on the intermediate layer, and traces in the first build-up layer are electrically connected to traces in the printed circuit board through a plurality of conductive vias in the intermediate layer.

2. The routing board according to claim 1, wherein the routing board further comprises:
a second build-up layer, located on the second surface of the printed circuit board.

3. The routing board according to claim 2, wherein both a material of an insulating medium in the intermediate layer and a material of an inter-layer insulating medium in the second build-up layer comprise a preset material, and the preset material comprises a build-up dielectric film ABF; and/or
the material of the inter-layer insulating medium in the second build-up layer further comprises a prepreg.

4. The routing board according to claim 1, wherein a material of an insulating medium in the intermediate layer comprises an epoxy molding compound EMC, and a material of an inter-layer insulating medium in the first build-up layer comprises a build-up dielectric film ABF.

5. The routing board according to claim 2, wherein the routing board further comprises: at least one pair of symmetric build-up layers, wherein each pair of symmetric build-up layers comprises a third build-up layer and a fourth build-up layer;
third build-up layers are provided in sequence on the first build-up layer; and
fourth build-up layers are provided in sequence on the second build-up layer.

6. The routing board according to claim 5, wherein a material of an insulating medium in the intermediate layer comprises a build-up dielectric film ABF, a material of an inter-layer insulating medium in the second build-up layer and a material of an inter-layer insulating medium in the printed circuit board are the same, and a material of an inter-layer insulating medium in the third build-up layer and a material of an inter-layer insulating medium in the fourth build-up layer are the same in each pair of symmetric build-up layers.

7. The routing board according to claim 5, wherein a thickness of the third build-up layer and a thickness of the fourth build-up layer are the same in each pair of symmetric build-up layers.

8. The routing board according to claim 1, 2, or 5, wherein at least one of the first build-up layer, the second build-up layer, the third build-up layer, and the fourth build-up layer is a redistribution layer.

9. A method for manufacturing a routing board, comprising:
preparing an auxiliary layer and a to-be-ground layer in sequence on a second surface of a pre-prepared printed circuit board;
grinding the to-be-ground layer, and press-grinding an intermediate layer film covering a first surface of the printed circuit board to form an intermediate layer; and
preparing a first build-up layer on the intermediate layer, and removing the auxiliary layer and a ground layer, to obtain the routing board.

10. The method according to claim 9, wherein the grinding the to-be-ground layer, and press-grinding an intermediate layer film covering a first surface of the printed circuit board to form an intermediate layer comprises:
press-grinding the intermediate layer film covering the first surface of the printed circuit board to form the intermediate layer after grinding the to-be-ground layer; or
grinding the to-be-ground layer after press-grinding the intermediate layer film covering the first surface of the printed circuit board to form the intermediate layer; or
grinding the to-be-ground layer while press-grinding the intermediate layer film covering the first surface of the printed circuit board to form the intermediate layer.

11. The method according to claim 9, wherein the method further comprises:
preparing a second build-up layer on the second surface of the printed circuit board after removing the auxiliary layer and the ground layer.

12. The method according to claim 11, wherein both a material of an insulating medium in the intermediate layer and a material of an inter-layer insulating medium in the second build-up layer comprise a preset material, and the preset material comprises a build-up dielectric film ABF; and/or
the material of the inter-layer insulating medium in the second build-up layer further comprises a prepreg.

13. The method according to claim 9, wherein a material of an insulating medium in the intermediate layer comprises an epoxy molding compound EMC, and a material of an inter-layer insulating medium in the first build-up layer comprises a build-up dielectric film ABF.

14. The method according to claim 11, wherein the method further comprises:
in a case that the routing board further comprises one symmetric build-up layer, forming a third build-up layer on the first build-up layer, and forming a fourth build-up layer on the second build-up layer; or
in a case that the routing board further comprises at least two symmetric build-up layers, forming a third build-up layer on the first build-up layer and forming a fourth build-up layer on the second build-up layer; and forming a third build-up layer in a next pair of symmetric build-up layers on the currently exposed third build-up layer and forming a fourth build-up layer in the next pair of symmetric build-up layers on the currently exposed fourth build-up layer, until all the symmetric build-up layers are prepared.

15. The method according to claim 14, wherein a material of an insulating medium in the intermediate layer comprises a build-up dielectric film ABF, a material of an inter-layer insulating medium in the second build-up layer and a material of an inter-layer insulating medium in the printed circuit board are the same, and a material of an inter-layer insulating medium in the third build-up layer and a material of an inter-layer insulating medium in the fourth build-up layer are the same in each pair of symmetric build-up layers.

16. The method according to claim 14, wherein a thickness of the third build-up layer and a thickness of the fourth build-up layer are the same in each pair of symmetric build-up layers.

17. The method according to claim 9, 11, or 14, wherein at least one of the first build-up layer, the second build-up layer, the third build-up layer, and the fourth build-up layer is a redistribution layer.
